# EUROPEAN PATENT APPLICATION

(11) **EP 4 027 395 A1**
(43) Date of publication of application: **13.07.2022**
(21) Application number: 20873407.9
(22) Date of filing: 13.08.2020
(51) Int. Cl.: H01L 31/0216, H01L 31/18

(54) **EFFICIENT BACK PASSIVATION CRYSTALLINE SILICON SOLAR CELL AND MANUFACTURING METHOD THEREFOR**

(30) Priority: 12.10.2019 CN 201910967301
(71) Applicant: Tongwei Solar (Chengdu) Co., Ltd., Chengdu, Sichuan 610000 (CN); Tongwei Solar (Meishan) Co., Ltd., Meishan, Sichuan 620041 (CN)
(72) Inventor: ZHANG, Peng, Chengdu, Sichuan 610000 (CN); CHEN, Kun, Chengdu, Sichuan 610000 (CN); WANG, Lan, Chengdu, Sichuan 610000 (CN); YIN, Zhiwei, Chengdu, Sichuan 610000 (CN)
(74) Representative: Dilg, Haeusler, Schindelmann Patentanwaltsgesellschaft mbH
(86) International application number: PCT/CN2020/108863
(87) International publication number: WO 2021/068644

(57) **Abstract**

An efficient back passivation crystalline silicon solar cell and a manufacturing method therefor. The cell comprises an Ag gate finger electrode (1), a SiNx passivation antireflection layer (2), an N+ layer (a phosphorus doped layer) (3), P-type silicon (4), a back passivation layer (5), and an Al gate finger electrode (6) which are connected sequentially from top to bottom. The Ag gate finger electrode (1) sequentially penetrates through the SiNx passivation antireflection layer (2) and the N+ layer (3) and is connected to the P-type silicon (4) by means of an N++ layer (a heavily doped silicon layer) (7). The Al gate finger electrode (6) penetrates through the back passivation layer (5) and is connected to the P-type silicon (4) by means of a P+ layer (local contact aluminum doped layer) (8). The back passivation layer (5) is of a passivation antireflection laminated structure, and the passivation antireflection laminated structure (5) comprises a SiO₂ passivation layer (51), an AlOx passivation layer (52), a SiNx antireflection layer (53), and a SiOxNy antireflection layer (54) which are sequentially provided from top to bottom. The solar cell has high carrier selectivity, high temperature stability, an excellent interface passivation effect, and excellent PID resistance, thereby achieving high conversion efficiency and high stability.

## Description

### Technical Field

The present disclosure relates to the field of back passivation solar cell, in particular to a high-efficient back-passivation crystalline-silicon solar cell (an efficient back passivation crystalline silicon solar cell) and manufacturing method therefor.

### Background Art

At present, solar cells mainly use crystalline silicon as the base material, due to the periodic damage on the surface of the silicon wafer, a large number of dangling bonds may be generated, so that there are a large number of defect energy levels located in the band gap on the surface of crystal; in addition, the dislocations, the chemical residues, and the deposition of surface metals may all introduce defect energy levels, so that the surface of the silicon wafer becomes a recombination center, resulting in a larger surface recombination rate, thereby limiting the conversion efficiency. Compared with conventional cells, the main advantages of back passivation cells are that the interface state on the back surface of the cell is reduced, the passivation capability is improved, and the long-wave response and short-circuit current are improved by extending the light distance, so that the conversion efficiency of the back passivation cells is improved by 1.0-1.2% or even more than the conventional cells. At present, the large-scale production in the industry uses the AlOX+SiNX structure as the main back passivation film layer, but the existence of Si-H and -NH bonds easily causes the film layer to be loose and accumulate a large number of pinholes, after high-temperature annealing, the detachment of hydrogen from the Si-H bond leaves unsaturated Si+, and bonding occurs between these surplus Si+, eventually forming silicon aggregates, also known as silicon islands, which directly affects the passivation effect, thus limiting the efficiency improvement of back passivation cells, which reduces the economic benefits of high-efficiency cell production.

### Summary

The purpose of the present disclosure is to solve the problem that the back passivation film layer of the existing back passivation solar cell is easy to form silicon aggregates in the production process, also known as silicon islands, which directly affects the overall effect of back passivation, leading to the problem of reducing the conversion efficiency of the cells. A high-efficiency back-passivation crystalline-silicon solar cell and a manufacturing method therefor are provided.

The technical solutions used in the present disclosure is as follows.

A high-efficient back-passivation crystalline-silicon solar cell comprises an Ag grid line electrode, a SiNx passivation antireflection layer, an N+ layer (a phosphorus doped layer), P-type silicon, a back passivation layer, and an Al grid line electrode, which are connected sequentially from top to bottom, wherein the Ag grid line electrode sequentially penetrates through the passivation film layer and the N+ layer and is connected to the P-type silicon by an N++ layer (a heavily doped silicon layer), the Al grid line electrode penetrates through the back passivation layer and is connected to the P-type silicon by a P+ layer (a local-contact aluminum doped layer), wherein the back passivation layer is of a passivation antireflection laminated structure, and the passivation antireflection laminated structure comprises a SiO₂ passivation layer, an AlOx passivation layer, a SiNx antireflection layer, and a SiOxNy antireflection layer, which are sequentially provided from top to bottom.

In the above technical solution, the thickness of the SiO₂ passivation layer is 0.3-3 nm.

In the above technical solution, the thickness of the AlOx passivation layer is 5-15 nm.

In the above technical solution, the thickness of the SiNx antireflection layer is 70-110nm, the refractive index is 1.9-2.2, and the structure thereof is single-layer, double-layer or triple-layer.

In the above technical solution, the thickness of the SiOxNy antireflection layer is 70-110 nm, and the refractive index is 1.8-2.0.

In a high-efficient back-passivation crystalline-silicon solar cell and a manufacturing method therefor, the manufacturing method comprises the following steps:
(a) placing the P-type silicon wafer in the groove to remove the damaged layer and performing texturing by using a method of alkali texturing, so as to form a pyramid texturing surface with a height of 0.5 µm-5 µm;
(b) using phosphorus oxychloride to perform high-temperature diffusion, wherein the reaction temperature is 750-850°C, and the reaction duration is 30-60min, to form an N+ layer on the surface of the P-type silicon wafer;
(c) using laser doping to form an N++ layer;
(d) using a wet etching process in combination with a HNO₃/HF mixed solution to remove the N+ layer on the back surface, and performing polishing treatment on the back surface;
(e) performing high-temperature annealing, wherein the reaction temperature is 750-850°C;
(f) using atomic layer deposition or plasma-enhanced chemical vapor deposition method to sequentially deposit SiO₂ passivation layer, AlOx passivation layer, SiNx antireflection layer and SiOxNy antireflection layer film on the back surface of P-type silicon wafer, so as to form a passivation antireflection laminated structure;
(g) using the plasma-enhanced chemical vapor deposition method to form a SiNx passivation antireflection layer on the front surface of the P-type silicon wafer;
(h) using laser etching to selectively etch off part of the passivation layer on the back surface of the P-type silicon wafer, so as to expose the silicon layer; and
(i) using the screen printing to print silver slurry on the front surface/aluminum slurry on the back surface of the P-type silicon wafer according to the screen graphic design, wherein after high-temperature sintering, an ohmic contact is formed, so as to obtain a high-efficiency back-passivation crystalline-silicon solar cell.

In the above technical solution, in the step (f), the silicon dioxide (SiO₂) layer is deposited by using O₂ or N₂O gas, wherein the reaction temperature is 600-850°C; the aluminum oxide (AlOx) layer is deposited by using a mixed gas of TMA and O₂ or N₂O, wherein the reaction temperature is 200-350°C; the silicon nitride (SiNx) layer is deposited by using a mixed gas of SiH₄ and NH₃, wherein the reaction temperature is 300-550°C; and the silicon oxynitride (SiOxNy) layer is deposited by using a mixed gas of SiH₄, NH₃ and N₂O, wherein the reaction temperature is 300-550°C.

To sum up, due to the adoption of the above-mentioned technical solutions, the beneficial effects of the present disclosure are as follows.

In the present disclosure, silicon dioxide (SiO₂) thin film is used on the bottom layer of the back surface of the back-passivation crystalline-silicon solar cell to reduce the contact resistance and enhance the passivation ability, which is beneficial to significantly reduce the recombination speed of the entire silicon wafer surface, and the top layer is made of silicon oxynitride (SiOxNy) thin film to enhance passivation and antireflection ability, because silicon oxynitride is a substance between silicon nitride (SiNx) and silicon dioxide (SiO₂), electrical and optical properties thereof are between the two, by changing its composition, the refractive index can be controlled between 1.47(SiO₂)-2.3(SiNx), as the oxygen content increases, it transforms into a SiO₂-based structure, and as the nitrogen content increases, it transforms into a structure with more SiNx components. The coating process can be optimized by plasma-enhanced chemical vapor deposition (PECVD), so that structure and performance thereof have some of the advantages of SiNx and SiO₂, and thus the passivation and antireflection performance are improved. Therefore, a SiO₂-AlOx-SiNx-SiOxNy laminated passivation antireflection film is formed on the back surface of the cell, which has high carrier selectivity, high temperature stability, excellent interface passivation effect, and excellent anti-PID ability, thereby achieving solar cells with high conversion efficiency, and high stability.

### Brief Description of Drawings

The present disclosure will be illustrated by way of embodiments and with reference to the accompanying drawings, wherein:

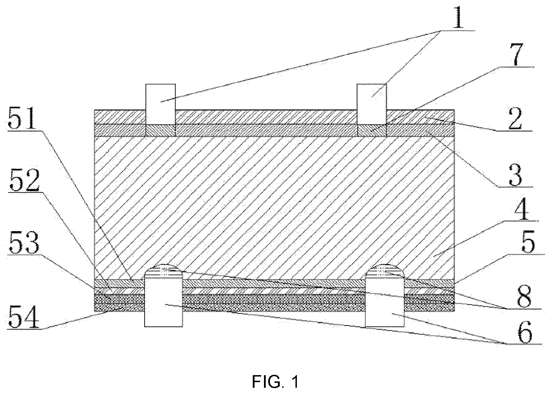

FIG. 1 is a structural schematic view of the present disclosure;
wherein the names of the parts corresponding to the reference signs are as follows: 1-Ag grid line electrode, 2-SiNx passivation antireflection layer, 3-N+ layer, 4-P-type silicon, 5-back passivation layer, 6-AI grid line electrode, 7-N++ layer, 8-P+ layer, 51-SiO₂ passivation layer, 52-AlOx passivation layer, 53-SiNx antireflection layer, 54-SiOxNy antireflection layer.

### Detailed Description of Embodiments

All features disclosed in this specification, or all disclosed steps in a method or process, may be combined in any way except mutually exclusive features and/or steps.

A high-efficient back-passivation crystalline-silicon solar cell comprises an Ag grid line electrode 1, a SiNx passivation antireflection layer 2, an N+ layer (a phosphorus doped layer) 3, P-type silicon 4, a back passivation layer 5, and an Al grid line electrode 6, which are connected sequentially from top to bottom, wherein the Ag grid line electrode 1 sequentially penetrates through the SiNx passivation antireflection layer 2 and the N+ layer 3 and is connected to the P-type silicon 4 by an N++ layer (a heavily doped silicon layer) 7, and the Al grid line electrode 6 penetrates through the back passivation layer 5 and is connected to the P-type silicon 4 by a P+ layer (a local-contact aluminum doped layer) 8, wherein the back passivation layer 5 is of a passivation antireflection laminated structure, and the passivation antireflection laminated structure comprises a SiO₂ passivation layer 51, an AlOx passivation layer 52, a SiNx antireflection layer 53, and a SiOxNy antireflection layer 54, which are sequentially arranged from top to bottom.

In the above technical solution, the thickness of the SiO₂ passivation layer 51 is 0.3-3 nm.

In the above technical solution, the thickness of the AlOx passivation layer 52 is 5-15 nm.

In the above technical solution, the thickness of the SiNx antireflection layer 53 is 70-110nm, the refractive index is 1.9-2.2, and the structure is single-layer, double-layer or triple-layer.

In the above technical solution, the thickness of the SiOxNy antireflection layer 54 is 70-110 nm, and the refractive index is 1.8-2.0.

### Example 1

A high-efficient back-passivation crystalline-silicon solar cell comprises an Ag grid line electrode 1, a SiNx passivation antireflection layer 2, an N+ layer (a phosphorus doped layer) 3, P-type silicon 4, a back passivation layer 5, and an Al grid line electrode 6 which are connected sequentially from top to bottom, wherein the Ag grid line electrode 1 sequentially penetrates through the SiNx passivation antireflection layer 2 and the N+ layer 3 and is connected to the P-type silicon 4 by an N++ layer (a heavily doped silicon layer) 7, the Al grid line electrode 6 penetrates through the back passivation layer 5 and is connected to the P-type silicon 4 by a P+ layer (a local contact aluminum doped layer) 8, wherein the back passivation layer 5 is of a passivation antireflection laminated structure, and the passivation antireflection laminated structure comprises a SiO₂ passivation layer 51, an AlOx passivation layer 52, a SiNx antireflection layer 53, and a SiOxNy antireflection layer 54 which are sequentially provided from top to bottom.

### Example 2

On the basis of Example 1, the thickness of the SiO₂ passivation layer 51 is 0.3nm.

### Example 3

On the basis of Example 1, the thickness of the SiO₂ passivation layer 51 is 3nm.

### Example 4

On the basis of above examples, the thickness of the AlOx passivation layer 52 is 5 nm.

### Example 5

On the basis of Example 1, 2 or 3, the thickness of the AlOx passivation layer 52 is 15 nm.

### Example 6

On the basis of above examples, the thickness of the SiNx antireflection layer 53 is 70nm, the refractive index is 1.9, and the structure is single-layer.

### Example 7

On the basis of any one of Examples 1-5, the thickness of the SiNx antireflection layer 53 is 110nm, the refractive index is 2.2, and the structure is double-layer.

### Example 8

On the basis of any one of Examples 1-5, the thickness of the SiNx antireflection layer 53 is 80nm, the refractive index is 2.0, and the structure is triple-layer.

### Example 9

On the basis of above examples, the thickness of the SiOxNy antireflection layer 54 is 70 nm, and the refractive index is 1.8.

### Example 10

On the basis of any one of Examples 1-8, the thickness of the SiOxNy antireflection layer 54 is 110 nm, and the refractive index is 2.0.

### Example 11

In a high-efficient back-passivation crystalline-silicon solar cell and a manufacturing method therefor, the manufacturing method comprises the following steps:
(a) placing the P-type silicon wafer in the groove to remove the damaged layer and performing texturing by using a method of alkali texturing, so as to form a pyramid texturing surface with a height of 0.5 µm-5 µm;
(b) performing high-temperature diffusion by using phosphorus oxychloride, wherein the reaction temperature is 750-850°C, and the reaction duration is 30-60min, to form an N+ layer on the surface of the P-type silicon wafer;
(c) using laser doping to form an N++ layer;
(d) using a wet etching process in combination with a HNO₃/HF mixed solution to remove the N+ layer on the back surface, and performing polishing treatment on the back surface;
(e) performing high-temperature annealing, wherein the reaction temperature is 750-850°C;
(f) sequentially depositing SiO₂ passivation layer, AlOx passivation layer, SiNx antireflection layer and SiOxNy antireflection layer film on the back surface of P-type silicon wafer by using atomic layer deposition or plasma-enhanced chemical vapor deposition method, so as to form a passivation antireflection laminated structure;
(g) forming a SiNx passivation antireflection layer on the front surface of the P-type silicon wafer by using the plasma-enhanced chemical vapor deposition method;
(h) using laser etching to selectively etch off part of the passivation layer on the back surface of the P-type silicon wafer, so as to expose the silicon layer; and
(i) using the screen printing to print silver slurry on the front surface/aluminum slurry on the back surface of the P-type silicon wafer according to the screen graphic design, wherein after high-temperature sintering, an ohmic contact is formed, so as to obtain a high-efficiency back-passivation crystalline-silicon solar cell.

In the embodiment, in the step (f), the silicon dioxide (SiO₂) layer is deposited by using O₂ or N₂O gas, wherein the reaction temperature is 600-850°C; the aluminum oxide (AlOx) layer is deposited by using a mixed gas of TMA and O₂ or N₂O, wherein the reaction temperature is 200-350°C; the silicon nitride (SiNx) layer is deposited by using a mixed gas of SiH₄ and NH₃, wherein the reaction temperature is 300-550°C; and the silicon oxynitride (SiOxNy) layer is deposited by using a mixed gas of SiH₄, NH₃ and N₂O, wherein the reaction temperature is 300-550°C.

The above are only preferred embodiments of the present disclosure, and are not intended to limit the present disclosure, the scope of protection of the present disclosure is subject to the claims, any equivalent structural changes made by using the description and accompanying drawings of the present disclosure, similarly, all should be included in the protection scope of the present disclosure.

## Claims

1. A high-efficient back-passivation crystalline-silicon solar cell, comprising an Ag grid line electrode (1), a SiNx passivation antireflection layer (2), an N+ layer (3), P-type silicon (4), a back passivation layer (5), and an Al grid line electrode (6), which are connected sequentially from top to bottom, wherein the Ag grid line electrode (1) sequentially penetrates through the SiNx passivation antireflection layer (2) and the N+ layer (3) and is connected to the P-type silicon (4) by an N++ layer (7), the Al grid line electrode (6) penetrates through the back passivation layer (5) and is connected to the P-type silicon (4) by a P+ layer (8), **characterized in that** the back passivation layer (5) is of a passivation antireflection laminated structure, and the passivation antireflection laminated structure comprises a SiO₂ passivation layer (51), an AlOx passivation layer (52), a SiNx antireflection layer (53), and a SiOxNy antireflection layer (54), which are sequentially provided from top to bottom.

2. The high-efficient back-passivation crystalline-silicon solar cell according to claim 1, wherein a thickness of the SiO₂ passivation layer (51) is 0.3-3 nm.

3. The high-efficient back-passivation crystalline-silicon solar cell according to claim 1, wherein a thickness of the AlOx passivation layer (52) is 5-15 nm.

4. The high-efficient back-passivation crystalline-silicon solar cell according to claim 1, wherein the SiNx antireflection layer (53) has a thickness of 70-110nm and a refractive index of 1.9-2.2, and is in a structure of single-layer, double-layer or triple-layer.

5. The high-efficient back-passivation crystalline-silicon solar cell according to claim 1, wherein the SiOxNy antireflection layer (54) has a thickness of 70-110 nm, and a refractive index of 1.8-2.0.

6. A manufacturing method for a high-efficient back-passivation crystalline-silicon solar cell, wherein the manufacturing method comprises following steps:
(a) placing a P-type silicon wafer in a groove to remove a damaged layer and performing texturing by using a method of alkali texturing, so as to form a pyramid texturing surface with a height of 0.5 µm-5 µm;
(b) performing high-temperature diffusion by using phosphorus oxychloride, wherein a reaction temperature is 750-850°C, and a reaction duration is 30-60min, to form an N+ layer on a surface of the P-type silicon wafer;
(c) using laser doping to form an N++ layer;
(d) using a wet etching process in combination with a HNO₃/HF mixed solution to remove an N+ layer on a back surface, and performing polishing treatment on the back surface;
(e) performing high-temperature annealing, wherein a reaction temperature is 750-850°C;
(f) sequentially depositing an SiO₂ passivation layer, an AlOx passivation layer, an SiNx antireflection layer and an SiOxNy antireflection layer film on the back surface of the P-type silicon wafer by using atomic layer deposition or plasma-enhanced chemical vapor deposition method, so as to form a passivation antireflection laminated structure;
(g) forming a SiNx passivation antireflection layer on a front surface of the P-type silicon wafer by using plasma-enhanced chemical vapor deposition method;
(h) using laser etching to selectively etch off part of the passivation layer on the back surface of the P-type silicon wafer, so as to expose the silicon layer; and
(i) using screen printing to print silver slurry on the front surface/aluminum slurry on the back surface of the P-type silicon wafer according to a screen graphic design, wherein after high-temperature sintering, an ohmic contact is formed, so as to obtain the high-efficiency back-passivation crystalline-silicon solar cell.

7. The manufacturing method for a high-efficient back-passivation crystalline-silicon solar cell according to claim 6, wherein the silicon dioxide (SiO₂) layer is deposited by using O₂ or N₂O gas, wherein a reaction temperature is 600-850°C; the aluminum oxide (AlOx) layer is deposited by using a mixed gas of TMA and O₂ or N₂O, wherein a reaction temperature is 200-350°C; the silicon nitride (SiNx) layer is deposited by using a mixed gas of SiH₄ and NH₃, wherein a reaction temperature is 300-550°C; and the silicon oxynitride (SiOxNy) layer is deposited by using a mixed gas of SiH₄, NH₃ and N₂O, wherein a reaction temperature is 300-550°C.
